# EUROPÄISCHE PATENTSCHRIFT

(11) **EP 0 689 491 B1**
(45) Veröffentlichungstag und Bekanntmachung des Hinweises auf die Patenterteilung: **26.11.1997**
(21) Anmeldenummer: 94911186.8
(22) Anmeldetag: 17.03.1994
(51) Int. Cl.: B23K 1/008, F27D 21/00

(54) **SMD-LÖTANLAGE**
SMD-SOLDERING INSTALLATION
INSTALLATION DE BRASAGE DE COMPOSANTS MONTES EN SURFACE

(30) Priorität: 19.03.1993 DE 9304076 U
(43) Veröffentlichungstag der Anmeldung: 03.01.1996
(73) Patentinhaber: FREDART SONDERMASCHINEN GmbH, D-40547 Düsseldorf (DE)
(72) Erfinder: KUCHENHART, Friedrich-Wilhelm, D-40547 Düsseldorf (DE)
(74) Vertreter: Sparing - Röhl - Henseler Patentanwälte
(86) Internationale Anmeldenummer: EP9400844
(87) Internationale Veröffentlichungsnummer: WO9421415

(56) Entgegenhaltungen:
- DE-A- 4 302 976
- US-A- 4 833 303
- PATENT ABSTRACTS OF JAPAN vol. 17, no. 649 (E-1468) 2. Dezember 1993 & JP,A,52 011 391 (HITACHI LTD) 20. August 1993

## Beschreibung

Die Erfindung betrifft eine SMD-Lötanlage. Die Abkürzung SMD (Surface Mounted Devices = Oberseitenbestückte Schaltplatinen) hat sich auch im deutschen Sprachgebrauch durchgesetzt. Für die Montage der Komponenten auf der oberseitigen Verdrahtung wird das sogenannte Reflow-Löten eingesetzt. Dabei werden die Lötpunkte -- vorzugsweise mittels entsprechender Handhabungsvorrichtungen -- mit Lötpaste versehen, und die Platine wird -- ebenfalls vorzugsweise mittels Handhabungsvorrichtungen -- mit den Komponenten bestückt. Danach wird die bestückte Leiterplatte (nachfolgend kurz als "Platine" bezeichnet) vorzugsweise mittels Strahlungswärme bis zur Löttemperatur erhitzt. Dieses Erhitzen erfolgt im allgemeinen in drei Temperaturstufen: In einer ersten Stufe wird bis etwa 100°C erwärmt, um die Lösungsmittel der Lötpaste auszutreiben. In einer zweiten Stufe wird die Platine bis wenig unter Schmelztemperatur des Lots durchgewärmt, um die gesamte Platine im wesentlichen auf dieselbe Temperatur zu bringen. In der dritten Stufe wird das Lot aufgeschmolzen.

Bekannte SMD-Reflow-Lötanlagen sind als Tunnelöfen aufgebaut, durch die die Platinen stetig gefördert werden.

Die bekannten Anlagen weisen einige Schwächen auf.

Einige SMD-Komponenten, insbesondere Halbleiterschaltkreise, sind so konzipiert, daß sie kurzzeitig die Schmelztemperatur des Lotes aushalten. Daraus folgt, daß die dritte Temperaturstufe so kurz wie möglich sein soll. Andererseits müssen aber auch alle Lötpunkte sicher aufschmelzen. Bei den bekannten Anlagen wird man für irgendeinen bestimmten Typ von Schaltung mehrere Versuche ausführen müssen, um die richtigen Parameter einstellen zu können. Trotzdem ist die Ausschußquote hoch, und Nachbesserungen sind, wenn überhaupt möglich, mit erheblichem Aufwand verbunden.

Es versteht sich, daß solche Durchlauflötanlagen für Massenproduktion konzipiert sind, weil die hohe Versuchs- und Ausfallquote bei Einzel- und Kleinserienfertigung unwirtschaftlich ist.

Ein dritter Nachteil der bekannten Anlagen besteht gerade in ihrer konzeptionellen Grundlage, die gesamte Platine möglichst gleichförmig bis zum Schmelzpunkt des Lotes zu erhitzen. Das zwingt nämlich den Konstrukteur, die einzelnen Komponenten entsprechend gleichförmig auf der Platinenoberfläche zu verteilen, ohne Rücksicht auf ihre funktionelle Verknüpfung mit daraus resultierender ungünstiger Leitungsführung.

Aufgabe der vorliegenden Erfindung ist es, wenigstens einige der vorgenannten Nachteile des Standes der Technik zu beheben oder wenigstens zu mildern.

Diese Aufgabe wird durch die Merkmale des Anspruchs 1 gelöst.

Gemäß der Erfindung ist vorgesehen, daß die Lötparameter (Temperatur-Zeit-Steuerung) nicht durch Probieren ermittelt werden, sondern daß das Aufschmelzen des Lots selbst beobachtet wird, so daß unmittelbar danach die Erwärmung abgebrochen werden kann. Dabei macht man sich vorzugsweise die Tatsache zunutze, daß die unterhalb des Schmelzpunkts stumpfgraue Lötpaste beim Aufschmelzen ihr Reflexionsverhalten radikal ändert, was sich beispielsweise mittels einer Videokamera sehr gut erfassen läßt.

Damit entfällt auch das Hindernis für den Einsatz der SMD-Technik bei Einzelplatinen oder Kleinserien, so daß man anstelle einer Durchlaufanlage auch ein für Einzelplatinen bestimmtes Gerät einsetzen kann. In diesem werden dann die drei Temperatur-Zeit-Abläufe nacheinander durchgeführt. Gemäß einem Aspekt der vorliegenden Erfindung kann jedoch ein solches Gerät auf größere Serien umgerüstet werden, indem man ihm einen Tunneldurchlaufofen vorschaltet, in welchem die ersten beiden Aufheizstufen realisiert werden, während das ergänzte Gerät nur noch die dritte, abschließende Stufe ausführt. Es versteht sich, daß der Durchlauf dann nicht stetig ist, sondern taktweise erfolgt.

Die Tatsache, daß die Platine während des eigentlichen Lötvorgangs stationär ist, erleichtert die Anwendung eines anderen Aspekts der vorliegenden Erfindung. Danach ist eine Vorrichtung vorgesehen, die es ermöglicht, ausgewählte Bereiche einer Platine zeitweise abzuschatten, so daß andere Bereiche, die höhere Wärmeabsorption aufweisen (z.B. Kühlkörper), länger aufgeheizt werden. Damit wird der Platinenkonstrukteur von den oben angegebenen Beschränkungen befreit.

Ein bevorzugtes Ausführungsbeispiel der Erfindung wird nachstehend unter Bezugnahme auf die beigefügten Zeichnungen im einzelnen erläutert. Dabei sind die Darstellungen weitgehend schematisiert, um wesentliche Einzelheiten deutlicher zeigen zu können.
Fig. 1 ist eine Seitenansicht der Gesamtanlage,
Fig. 2 ist eine Draufsicht auf die Anlage nach Fig. 1,
Fig. 3 stellt in etwas größerem Maßstab das Einzelgerät aus der Anlage nach Fig. 1 und 2 dar,
Fig. 4 ist eine Ansicht in Richtung des Pfeiles "4" in Fig. 3, und
Fig. 5 illustriert die Blendenanordnung für das Sichtgerät.

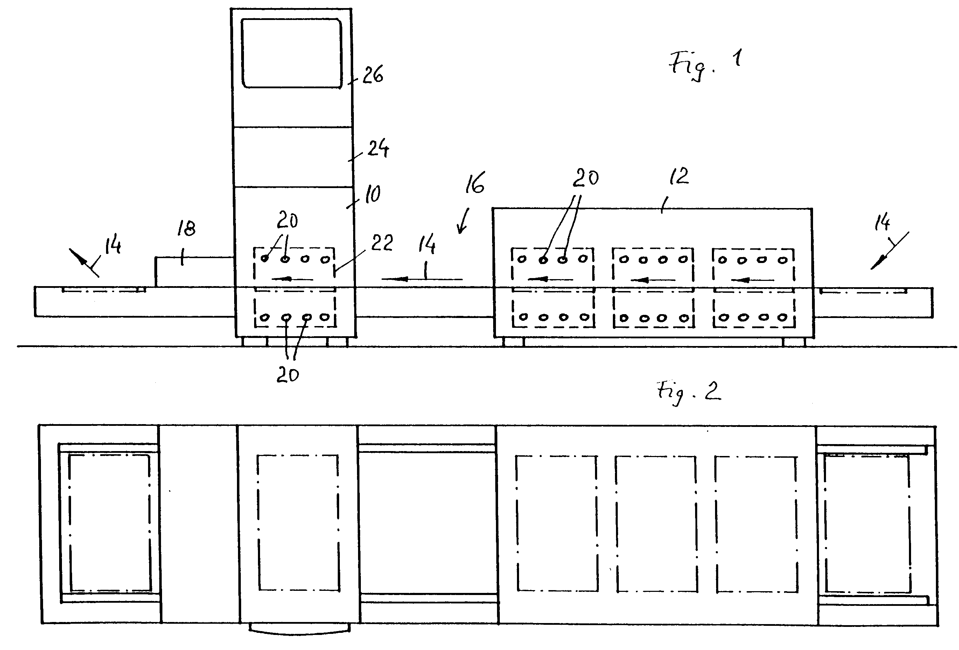

Die Anlage gemäß Figur 1 umfaßt das Endstufengerät 10 und den vorgeschalteten Tunnelofen 12, die taktweise von den bestückten Platinen in Richtung der Pfeile 14 durchlaufen werden. Zwischen beiden ist eine hier offen dargestellte Übergabestation 16 vorgesehen, die es ermöglicht, bei ausgeschaltetem (oder nicht vorhandenem) Tunnelofen 12 das Endstufengerät direkt mit bestückten Leiterplatten zu beschicken; die Steuerung des Endstufengeräts ist so ausgelegt, daß es entweder nur das Aufheizen von dem mittleren Temperaturniveau (erzeugt durch den Tunnelofen) bis zum Aufschmelzen des Lots besorgt oder aber alternativ alle drei Temperaturniveaus zu durchfahren gestattet. An der Auslaßseite des Endstufengeräts 10 befindet sich ein Anbaugehäuse 18, dessen Funktion später beschrieben wird.

In den Zeichnungen sind die Heizstrahler 20, bei denen es sich vorzugsweise um Mittelwellen-Infrarotstrahler handelt, angedeutet. Solche Strahler sind handelsüblich, haben nur geringe Trägheit und können beispielsweise zur Temperatursteuerung über ein Phasenanschnittgerät angesteuert werden. Der Aufbau der Steuerung bietet dem Fachmann keinerlei Schwierigkeiten und stellt keinen Teil der vorliegenden Erfindung dar.

Oberhalb des eigentlichen Aufheizraumes 22 weist das Endstufengerät 10 ein Zwischengehäuse 24 zur Aufnahme der Beobachtungskamera 25 auf, über dem sich ein Bildschirmmonitor 26 befindet.

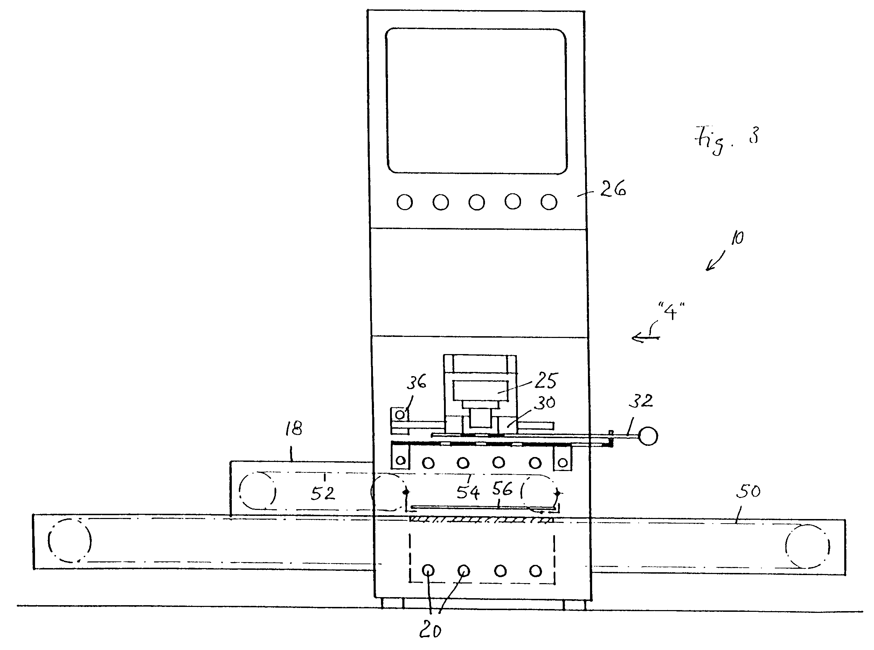

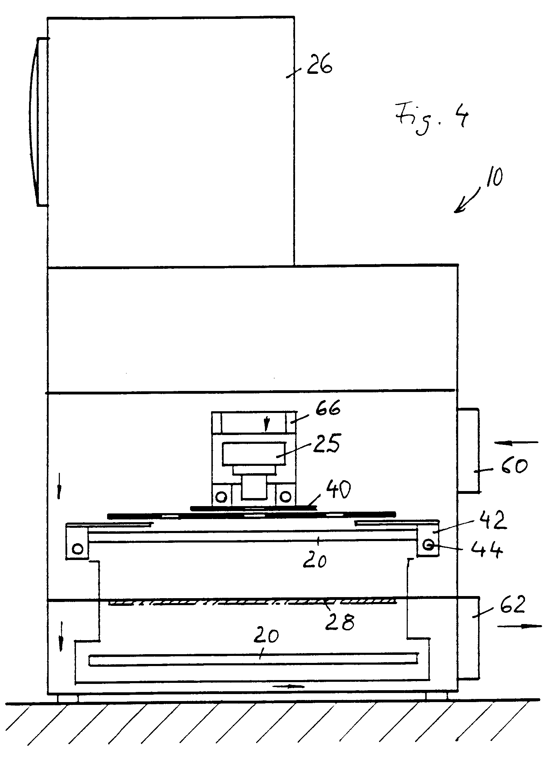

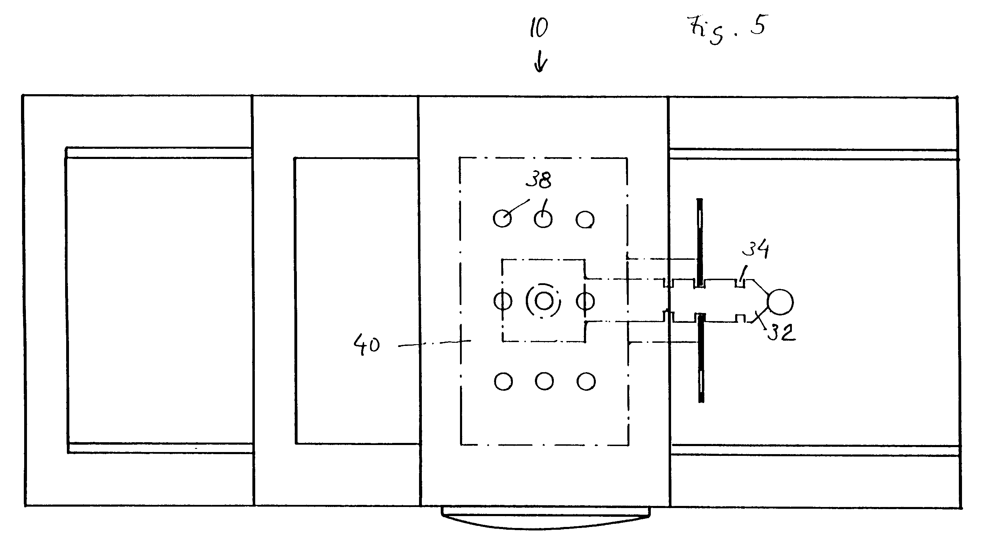

Der Aufbau des Endstufengeräts 10 ist in den Figuren 3 bis 5 in größeren Einzelheiten dargestellt. Die Beobachtungskamera, bei der es sich um eine handelsübliche Videokamera für Überwachungszwecke und dergleichen handeln kann, ist senkrecht nach unten auf die mittels eines Kettenförderers herangeführte Platine gerichtet, die auf einem rahmenartigen Träger 28 liegt. Das Ausgangssignal der Kamera wird dem Monitor 26 zugeführt. Die Optik der Kamera ist absichtlich nicht auf die Oberseite der Platine fokussiert, so daß das von ihr "gesehene" Bild auf dem Monitor unscharf erscheint; da solche Kameras normalerweise eine Helligkeitsregelung aufweisen, zeigt der Bildschirm des Monitors zunächst im wesentlichen eine gleichförmig graue Fläche. Sobald jedoch das Lot aufschmilzt, reflektieren die Lottröpfchen einen erheblichen Anteil des in der Strahlung enthaltenen sichtbaren Lichts in die Kameraoptik, und auf dem Bildschirm des Monitors erscheint ein sternschnuppenartiges Bild. Dies ist für den Bediener das Signal, die Heizung abzuschalten und/oder die Platine aus dem Aufheizraum 22 herauszutransportieren und gegebenenfalls einer Kühlung etwa mittels eines Gebläses zu unterwerfen.

Es versteht sich, daß der Bediener auch durch eine Bilderkennungsvorrichtung ersetzbar wäre, oder daß man auf den Monitor ganz verzichtet und die Videoausgangssignale der Kamera unmittelbar auswertet.

Wie in den Zeichnungen erkennbar, muß die Kamera jeweils zwischen zwei Heizstrahlern hindurch "sehen". Sie kann also immer nur einen Ausschnitt der Platine erfassen, wenn die volle Breite des Geräts ausgenützt wird. Um trotzdem alle Teile der Platine überprüfen zu können, ist die Kamera 25 auf einem Schlitten 30 montiert, der mittels eines Handhebels 32 in drei durch Rasten 34 vorgegebene Positionen verfahrbar ist. Der Schlitten 30 seinerseits sitzt auf einem Gleitstück 36, das quer zur Schlittenverlagerung ebenfalls mittels des Handhebels 32 zwischen drei Rastpositionen verschieblich ist. Jeder der neun Rastpositionen ist einer Sichtöffnung 38 in einer Blende 40 zugeordnet. Schließlich ist das gesamte, aus den oberen Heizstrahlern, ihrem Rahmen 42, der Blende 40 und der Kamera samt Rasteinrichtungen bestehende System noch auf Schienen 44 gleitverlagerbar, so daß tatsächlich alle Punkte der Platine in den Sichtbereich der Kamera bringbar sind, ohne daß die Kamera direkt auf einen Strahler gerichtet wird.

Es versteht sich, daß die Kamera auch seitlich angeordnet werden könnte und das Bild über Spiegel, die gegebenenfalls beweglich sind, in ihre Optik projiziert werden kann. Es versteht sich ferner, daß die Kamera auch durch einen Zeilensensor mit vorgeschaltetem rotierendem Polygonspiegel oder analoge Mittel ersetzt werden kann. Es versteht sich schließlich auch, daß die manuelle Verlagerung der Kamera durch motorische Antriebe erleichtert werden könnte.

In Figur 3 sind die Förderketten 50 für die Platinen angedeutet. Zwei weitere Paare von Ketten 52, 54 erstrecken sich durch das Anbaugehäuse 18 in das Innere des Heizraums. Sie können von einem (nicht dargesstellten) Motor hinundhergehend angetrieben werden. An diesen Kettenpaaren ist ein Maskenträger 56 aufgehangen, der aus einer Position außerhalb des Heizraumes mittels der Kettenpaare in den Heizraum hineinverlagerbar und auf eine Platine absenkbar ist, um ausgewählte Bereiche derselben für eine vorgegebene Zeit gegen die Strahlung von oben abzuschatten. Das ist natürlich nur während der eigentlichen Lötperiode sinnvoll, da vorher gezielt eine gleichförmige Durchwärmung aller Teile der Platine angestrebt wird. Die beispielsweise aus einer Aluminiumfolie bestehende Maske wird für die jeweilige Leiterplatte einfach zurechtgeschnitten.

Es versteht sich, daß andere Mechanismen für die Verlagerung des Maskenträgers vorstellbar sind, wie Hebelgestänge und dergleichen.

Die Gerätegehäuse sind doppelwandig ausgeführt und mittels Druckgebläsen 60 und Sauggebläsen 62 zwangsgekühlt. Die Kühlluftführung ist in Fig. 4 durch die Pfeile 64 angedeutet. Die Kamera hat ein eigenes Kühlgebläse 66.

## Patentansprüche

1. Lötgerät für das Reflow-Löten von SMD-Leiterplatten mit einer optischen Einrichtung (25) zum Erkennen des aufschmelzenden Lots.

2. Lötgerät nach Anspruch 1, bei dem die optische Einrichtung eine Videokamera (25) umfaßt.

3. Lötgerät nach Anspruch 2, bei dem ein Wiedergabegerät (26) an die Kamera (25) angeschlossen ist.

4. Lötgerät nach Anspruch 3, bei dem die Kamera (25) für die Wiedergabe aufblitzender Lötstellen vor weitgehend neutralem Hintergrund fehlfokussiert ist.

5. Lötgerät nach einem der vorangehenden Ansprüche, bei dem die optische Einrichtung (25) erst nach Ablauf einer Vorheizphase einsetzbar ist.

6. Lötgerät für das Reflow-Löten von SMD-Leiterplatten nach einem der vorangehenden Ansprüche, bei dem in einer ersten Aufheizperiode die Leiterplatten auf ein erstes Temperaturniveau aufgeheizt werden, in einer zweiten Aufheizperiode die Leiterplatten auf ein zweites Temperaturniveau aufgeheizt werden und in einer dritten Aufheizperiode das Lot bis zum Aufschmelzen erwärmt wird, welches Gerät aus einem Tunnelofen (12) für die ersten beiden Aufheizperioden und einem Endstufengerät (10) für die dritte Aufheizperiode besteht und bei dem die Leiterplatten taktweise durch den Tunnelofen (12) und das Endstufengerät (10) gefördert werden.

7. Lötgerät nach Anspruch 6, bei dem das Endstufengerät (10) so steuerbar ist, daß in ihm auch die ersten beiden Aufheizperioden ausführbar sind.

8. Lötgerät für das Reflow-Löten von SMD-Leiterplatten nach einem der vorangehenden Ansprüche, bei dem ausgehend von einem Vorheiz-Temperaturniveau, auf das die Leiterplatten gleichförmig aufgeheizt worden sind, ein Heizstrahlersystem (20) Strahlungswärme bis zum Aufschmelzen des Lotes zuführt, und das eine Vorrichtung (56) umfaßt, mittels der ausgewählte Teile einer Leiterplatte zeitweilig vor der Strahlungswärme abschirmbar sind.

## Claims

1. Soldering apparatus for reflow-soldering of SMD circuit boards amprising an optical device (25) for recognizing the melting solder.

2. Soldering apparatus as in claim 1 wherein the optical device comprises a video camera (25).

3. Soldering apparatus as in claim 2 wherein a display device (26) is connected to the camera (25).

4. Soldering apparatus as in claim 3 wherein the camera (25) is misfocussed so as to display flashing solder spots in front of substantially neutral background.

5. Soldering apparatus as in one of the preceding claims wherein the optical device (25) is operable only after expiration of a preheating phase.

6. Soldering apparatus for reflow soldering of SMD circuit boards as in one of the preceding claims wherein, in a first heating period, the boards are heated to a first temperature level, in a second heating period, the boards are heated to a second temperature level, and in a third heating period, the solder is heated until its melting, the apparatus comprising a tunnel furnace (12) for the first two heating periods and a terminal apparatus (10) for the third heating period, and wherein the circuit boards are stepwisely conveyed through the tunnel furnace (12) and the terminal apparatus (10).

7. Soldering apparatus as in claim 6 wherein the terminal apparatus (10) is adapted to be controlled such that the first two heating periods, too, may be implemented therein.

8. Soldering apparatus for reflow soldering of SMD circuit boards as in one of the preceding claims wherein, starting from a preheating temperature level to which the circuit boards have been uniformly heated, a radiation heating system (20) supplies radiation heat until melting of the solder, the apparatus comprising a device (56) by means of which selected portions of the circuit board may temporarily be shielded against the radiation heat.

## Revendications

1. Appareil de soudage pour le soudage par refusion de cartes de circuit imprimé SMD, comportant un dispositif optique (25) pour la reconnaissance de la soudure fondante.

2. Appareil de soudage selon la revendication 1, dans lequel le dispositif optique comprend une caméra vidéo (25).

3. Appareil de soudage selon la revendication 2, dans lequel un équipement de reproduction (26) est branché sur la caméra (25).

4. Appareil de soudage selon la revendication 3, dans lequel la caméra est focalisée de manière incorrecte pour la restitution d'endroits de soudure étincelants devant un arrière-plan en majeure partie neutre.

5. Appareil de soudage selon l'une des revendications précédentes, dans lequel ledit dispositif optique (25) n'est enclenché qu'après le déroulement d'une phase de préchauffage.

6. Appareil de soudage pour le soudage par refusion de cartes de circuit imprimé SMD selon l'une des revendications précédentes, dans lequel les cartes de circuit imprimé sont portées à un premier niveau de température au cours d'une première période de chauffage, les cartes de circuit imprimé sont portées à un deuxième niveau de température au cours d'une deuxième période de chauffage et la soudure est chauffée jusqu'à la fusion au cours d'une troisième période de chauffage, ledit appareil comprenant un four-tunnel (12) pour les deux premières périodes de chauffage et un appareil de finition (10) pour la troisième période et dans lequel les cartes de circuit imprimé sont transportées par pas à travers le four-tunnel (12) et l'appareil de finition (10).

7. Appareil de soudage selon la revendication 6, dans lequel l'appareil de finition (10) peut être commandé de sorte que les deux premières périodes de chauffage. peuvent aussi être réalisées dans celui-ci.

8. Appareil de soudage pour le soudage par refusion de cartes de circuit imprimé SMD selon l'une des revendications précédentes, dans lequel, à partir d'un niveau de température de préchauffage auquel les cartes de circuit imprimé ont été chauffées de façon uniforme, un système de chauffage par rayonnement (20) fournit de la chaleur rayonnante jusqu'à la fusion de la soudure et qui comprend un dispositif (56) au moyen duquel des parties choisies d'une carte de circuit imprimé peuvent être momentanément protégées de la chaleur rayonnante.
